# EUROPÄISCHE PATENTSCHRIFT

(11) **EP 2 912 931 B1**
(45) Veröffentlichungstag und Bekanntmachung des Hinweises auf die Patenterteilung: **29.04.2020**
(21) Anmeldenummer: 13783258.0
(22) Anmeldetag: 24.10.2013
(51) Int. Cl.: H05K 7/14, H01R 9/26, H02B 1/056, H01R 13/639

(54) **GEHÄUSE FÜR AN EINER TRAGSCHIENE ANBRINGBARE UND ANEINANDER ANREIHBARE VORRICHTUNGEN, ZUGEHÖRIGES GEHÄUSE-BAUKASTENSYSTEM UND VORRICHTUNG MIT EINEM SOLCHEN GEHÄUSE**
CASING FOR DEVICES MOUNTED SIDE BY SIDE ON A RAIL, ASSOCIATED MODULAR CASING SYSTEM AND DEVIVE WITH SUCH A CASING
BOÎTIER POUR APPAREILS MONTÉS CÔTE À CÔTE SUR UN RAIL AINSI QUE SYSTÈME MODULAIRE ASSOCIÉ ET APPAREILS AVEC UN TEL BOÎTIER.

(30) Priorität: 25.10.2012 DE 102012021055
(43) Veröffentlichungstag der Anmeldung: 02.09.2015
(73) Patentinhaber: Friedrich Lütze GmbH, 71366 Weinstadt-Gro Heppach (DE)
(72) Erfinder: ROTH, Markus, 71384 Weinstadt (DE); ERKER, Hubert, 73333 Gingen (DE); LANG, Jürgen, 71640 Ludwigsburg (DE); GHIZELEA, Virgil, 70372 Stuttgart (DE); COORS, Rlaf, 96170 Priesendorf (DE)
(74) Vertreter: Bartels und Partner, Patentanwälte
(86) Internationale Anmeldenummer: PCT/EP2013/003205
(87) Internationale Veröffentlichungsnummer: WO 2014/063821

(56) Entgegenhaltungen:
- EP-A1- 0 661 915
- EP-B1- 1 029 389
- WO-A1-2009/060548
- WO-A1-2011/070042
- DE-A1- 3 600 590
- DE-A1- 19 748 429
- DE-T2- 69 415 164
- US-A1- 2007 155 221

## Beschreibung

Die Erfindung betrifft ein Gehäuse für an einer Tragschiene anbringbare und aneinander anreihbare Vorrichtungen mit den Merkmalen im Oberbegriff von Anspruch 1, ein zugehöriges Gehäuse-Baukastensystem sowie eine Vorrichtung mit einem solchen Gehäuse.

Beispielsweise in der industriellen Steuerungstechnik werden elektrische und/oder elektronische Geräte häufig in Schaltschränken oder Schaltkästen angeordnet. Die einzelnen Vorrichtungen werden auf Tragschienen wie beispielsweise einer genormten Hutschiene angeordnet und können aneinander gereiht werden. Ein zugehöriges Montagesystem wird von der Anmelderin Friedrich Lütze GmbH in 71384 Weinstadt unter dem Produktnamen LSC-Verdrahtungssystem angeboten.

Traditionell erfolgt die Verbindung der einzelnen Vorrichtungen durch Verbindungsleitungen, beispielsweise einadrige Kabel, die mittels Klemmen an den einzelnen Vorrichtungen angeschlossen werden. Dies gilt grundsätzlich auch für Energieversorgungsleitungen. Aus der DE 201 08 460 U1 ist ein modulares Bausatzsystem bekannt, bei dem mit Brückungssteckern zwei nebeneinander angeordnete Modulträger elektrisch kontaktierbar sind.

Dadurch können Phasenleiter durch mehrere der Reihenklemmen drahtlos durchgeführt werden.

Die DE 197 48 429 A1 beschreibt ein Gehäuse für an einer Tragschiene anbringbare und aneinander anreihbare Vorrichtungen, insbesondere Reihenelektronikgehäuse, mit den Merkmalen im Oberbegriff von Anspruch 1, wobei das Gehäuse ein erstes Gehäuseteil aufweist, mittels dem die Vorrichtung an der Tragschiene anbringbar ist, wobei das erste Gehäuseteil mindestens zwei Aufnahmeeinrichtungen zum Festlegen von jeweils einem Koppelmodul an dem ersten Gehäuseteil aufweist, und wobei an den mindestens zwei, vorzugsweise beabstandet voneinander in dem ersten Gehäuseteil angeordneten Aufnahmeeinrichtungen entweder ein Koppelmodul zum Koppeln von Energieversorgungsleitungen zwischen zwei benachbart zueinander an der Tragschiene angeordneten Vorrichtungen festlegbar ist oder ein Koppelmodul zum Koppeln von Signalleitungen zwischen zwei benachbart zueinander an der Tragschiene angeordneten Vorrichtungen festlegbar ist, wobei ein zweites Gehäuseteil mit dem ersten Gehäuseteil mittels eines elastisch auslenkbaren Rastmittels lösbar verbindbar ist. Weitere Gehäuse gehen aus der EP 1 029 389 B1, der EP 0 661 915 A1, der US 2007/0155221 A1, der DE 36 00 590 A1 und der WO 2009/ 060548 A1 hervor.

Die DE 694 15 164 T2 offenbart einen elektrischen Verbinder mit einem Verbinder-Lagesicherungssystem bestehend aus einem auslenkbaren Verriegelungsarm und einem Verriegelungsschieber, der in der Verriegelungsposition die Auslenkung des Verriegelungsarms blockiert.

Der vorliegenden Erfindung liegt die Aufgabe zugrunde, ein neues Gehäuse für an einer Tragschiene anbringbare und aneinander anreihbare Vorrichtungen sowie ein zugehöriges Gehäuse-Baukastensystem und eine Vorrichtung mit einem solchen Gehäuse bereitzustellen, das verbesserte Gebrauchseigenschaften aufweist, insbesondere vielseitig einsetzbar ist und dabei einfach in der Handhabung und Montage ist.

In einer Ausführungsart ist die Aufgabe durch das im Anspruch 1 bestimmte Gehäuse sowie durch das Gehäuse-Baukastensystem gemäß Anspruch 6 und die Vorrichtung gemäß Anspruch 13 gelöst. Besondere Ausführungsarten der Erfindung sind in den Unteransprüchen bestimmt.

Gemäß den Kennzeichen von Anspruch 1 ist vorgesehen, dass die Auslenkung des Rastmittels durch ein beweglich am zweiten Gehäuse-,teil gelagertes Blockierelement blockierbar ist und dadurch der mit dem ersten Gehäuseteil verbundene Zustand des zweiten Gehäuseteils sicherbar ist, und dass das Blockierelement in dem zweiten Gehäuseteil verschiebbar gelagert ist.

In einer Ausführungsart betrifft die Erfindung ein Gehäuse für auf einer Tragschiene anbringbare und aneinander anreihbare Vorrichtungen, insbesondere ein Reihenelektronikgehäuse. Das Gehäuse weist ein erstes Gehäuseteil auf, mittels dem die Vorrichtung an der Tragschiene anbringbar ist. Das erste Gehäuseteil weist mindestens zwei Aufnahmeeinrichtungen zum Festlegen von jeweils einem Koppelmodul an dem ersten Gehäuseteil auf. An mindestens zwei, vorzugsweise beabstandet voneinander in dem ersten Gehäuseteil angeordneten Aufnahmeeinrichtungen ist entweder ein Koppelmodul zum Koppeln von Energieversorgungsleitungen zwischen zwei benachbart zueinander auf der Tragschiene angeordneten Vorrichtungen oder ein Koppelmodul zum Koppeln von Signalleitungen zwischen zwei benachbart zueinander auf der Tragschiene angeordneten Vorrichtungen festlegbar.

An das erste Gehäuseteil, das sockelartig ausgebildet sein kann, können ein oder mehrere weitere Gehäuseteile anschließen, insbesondere auf das Gehäuseteil aufgesteckt werden. Gemeinsam schließen die Gehäuseteile eine beispielsweise elektrische Schaltungsanordnung, die innerhalb des Gehäuses angeordnet ist, gegenüber der Umgebung ab. Bei den Vorrichtungen kann es sich beispielsweise um elektrische Vorrichtungen handeln, etwa Stromversorgungen, Sicherungen, Steuerungen, Ein-/Ausgabe-Baugruppen, Schnittstelleneinheiten, Temperaturwandler, Analog/Digital-Wandler oder dergleichen. Alternativ oder ergänzend kann die Vorrichtung auch nichtelektrische Komponenten aufweisen, beispielsweise optische Komponenten oder pneumatische Komponenten. Dementsprechend kann es sich bei den Energieversorgungsleitungen nicht nur um elektrische Leitungen handeln, sondern beispielsweise auch um pneumatische Energieversorgungsleitungen. Entsprechendes gilt für die Signalleitungen.

Dadurch, dass das erste Gehäuseteil mindestens zwei Koppelmodule wahlweise aufnehmen kann, ist das Gehäuse vielseitig einsetzbar und kann dennoch alle Sicherheitsanforderungen erfüllen. So können beispielsweise für elektrische Energieversorgungsleitungen unterschiedliche Koppelmodule für unterschiedliche Spannungs- oder Leistungsanforderungen eingesetzt werden, ohne dass das erste Gehäuseteil entsprechend modifiziert werden muss. So können etwa neben den in der industriellen Steuerungstechnik weit verbreiteten 24 V-Energieversorgungsleitungen durch ein modifiziertes Koppelmodul auch höhere Spannungen von beispielsweise 500 V eingekoppelt werden, oder auch höhere Stromanschlüsse von beispielsweise bis zu 16 A. Es können innerhalb eines Koppelmoduls auch unterschiedlich hohe Spannungen und/oder unterschiedliche Spannungsarten (AC, DC) koppelbar sein, beispielsweise können bei einem mehrpoligen Koppelmodul zwei Pole für eine Gleichspannung von 24 V vorgesehen sein und zwei weitere Pole für eine Gleichspannung von 5 V. Die Anpassung des Gehäuses kann dabei auch an der Montagestelle vor Ort vorgenommen werden, indem das passende Koppelmodul erst an der Montagestelle in das erste Gehäuseteil eingesetzt wird.

Alternativ oder ergänzend zu den Koppelmodulen für die Energieversorgung kann auch ein oder mehrere Koppelmodule zum Koppeln von Signalleitungen in einer Aufnahmeeinrichtung des ersten Gehäuseteils festgelegt werden. Dabei kann es sich beispielsweise um elektrische analoge Signalleitungen handeln, etwa das Ausgangssignal eines Temperatursensors, die mittels des zugehörigen Koppelmoduls von einer Vorrichtung zu der benachbarten Vorrichtung durchverbindbar sind. In einer bevorzugten Ausführungsart handelt es sich bei den Signalleitungen um Datenbusleitungen, beispielsweise einen Feldbus oder eine Datenschnittstelle, die durch die zugehörigen Koppelmodule auch entlang einer Kette von aneinandergereihten Vorrichtungen durchschleifbar sind. Durch die Koppelmöglichkeit entfällt das manuelle Verdrahten von Signalleitungen, beispielsweise über Klemmverbindungen oder Steckverbindungen an einer Seitenfläche oder an der Frontseite der Vorrichtungen. Dadurch ist zum einen die Betriebssicherheit erhöht, weil die Koppel- oder Verbindungsstellen im montierten Zustand durch das Gehäuse abgedeckt sind, und zum anderen ist die Montage deutlich vereinfacht und auch die Montagesicherheit erhöht, weil Fehlverbindungen zuverlässig verhindert sind.

Hierzu ist es besonders vorteilhaft, wenn an mindestens einer der Aufnahmeeinrichtungen, vorzugsweise an allen Aufnahmeeinrichtungen des ersten Gehäuseteils, das zugehörige Koppelmodul lösbar, insbesondere werkzeuglos lösbar, festlegbar ist. Ergänzend kann noch ein Sicherungselement vorgesehen sein, beispielsweise eine oder mehrere Sicherungsschrauben, mit denen der festgelegte und verrastete Zustand des Koppelmoduls sicherbar ist. Das Sicherungselement kann zusätzlich durch einen Siegellack oder ein anderes Fixiermittel in seiner sichernden Position fixierbar sein.

In einer Ausführungsart weist mindestens eine Aufnahmeeinrichtung, vorzugsweise alle Aufnahmeeinrichtungen, mindestens ein Rastelement auf, mit dem das Koppelmodul beim Festlegen an dem ersten Gehäuseteil in Eingriff bringbar ist. Mindestens ein Teil der Rastelemente, vorzugsweise alle Rastelemente, ist integral von jenen Seitenwänden des ersten Gehäuseteils ausgebildet, die quer zur Längsachse der Tragschiene verlaufen oder quer zu einer Längsachse einer von dem ersten Gehäuseteil vorzugsweise einstückig ausgebildeten Aufnahme für die Tragschiene. Durch die Rastelemente ist eine einfache Montage der Koppelmodule gewährleistet. Durch die Anordnung der Rastelemente an den längeren und dadurch weniger steifen Seitenwänden sind die beim Einsetzen und Lösen der Koppelmodule erforderlichen Kräfte reduziert.

In einer Ausführungsart ist in mindestens einer der Aufnahmeeinrichtungen ein Koppelmodul festlegbar, mit dem mindestens eine vorzugsweise elektrische Signalleitung, vorzugsweise mehrere Signalleitungen, insbesondere ein Datenbus mit einer genormten Schnittstelle, zwischen zwei benachbart auf der Tragschiene angebrachten Vorrichtungen koppelbar. Dadurch entfällt die Verwendung von Schnittstellenkabeln, die an einer Seitenfläche oder Frontfläche der Vorrichtungen angeschlossen werden müssen. Vielmehr kann auf einfache Weise ein Datenbus durch benachbart zueinander angeordnete Vorrichtungen durchgeschleift werden. Durch Auswahl eines geeigneten Koppelmoduls sind unterschiedliche Signalleitungen koppelbar. So können beispielsweise an den jeweiligen Feldbus angepasste Koppelmodule auch noch im montierten Zustand des ersten Gehäuseteils eingesetzt werden.

In einer Ausführungsart weist mindestens eines der in dem ersten Gehäuseteil festgelegten Koppelmodule an oder nahe seinen einander gegenüberliegenden Rändern jeweils Anschlussstellen auf, insbesondere Steckkontakte, zum Koppeln von Signal- oder Energieversorgungsleitungen zu einer benachbart auf der Tragschiene angeordneten Vorrichtung mittels eines vorzugsweise steckbaren Koppelelements. Zwischen den Anschlussstellen des Koppelmoduls, die den benachbart auf der Tragschiene angeordneten Vorrichtungen zugeordnet sind, weist das Koppelmodul mindestens eine weitere Anschlussstelle auf, insbesondere mindestens einen weiteren Steckkontakt, für im Gehäuse angeordnete Komponenten der Vorrichtung. Auf diese Weise ist mit kurzen und gegebenenfalls auch hochstromtragfähigen Verdrahtungswegen ein zuverlässiger Anschluss der im Gehäuse angeordneten Komponenten der Vorrichtung gewährleistet.

Erfindungsgemäß weist das Gehäuse ein zweites Gehäuseteil auf, das mit dem ersten Gehäuseteil mittels eines elastisch auslenkbaren Rastmittels lösbar verbindbar ist. Die Auslenkung des Rastmittels ist durch ein beweglich am zweiten Gehäuseteil gelagertes Blockierelement blockierbar. Dadurch ist der mit dem ersten Gehäuseteil verbundene Zustand des zweiten Gehäuseteils sicherbar.

Das Rastmittel kann an jenem Gehäuseteil angeordnet sein, vorzugsweise einstückig von diesem ausgebildet sein, an dem auch das Blockierelement beweglich gelagert ist. Das Blockierelement ist verschiebbar gelagert. Das Blockierelement kann in seinem das Rastmittel blockierenden Zustand in Anlage an dem Rastmittel sein. Das Blockierelement kann unverlierbar an dem Gehäuseteil angeordnet sein. Das Blockierelement kann vorzugsweise einstückig ausgebildet ein Griffstück aufweisen, mittels dem das zweite Gehäuseteil, an dem das Blockierelement angeordnet ist, dem anderen Gehäuseteil abnehmbar ist, insbesondere abziehbar ist, beispielsweise von einem Gehäusesockel abziehbar und abnehmbar ist. Das Blockierelement kann, insbesondere in einem Griffstück, eine Werkzeugangriffsfläche aufweisen.

Die Erfindung betrifft auch ein Gehäuse-Baukastensystem für auf einer Tragschiene anbringbare und aneinander anreihbare Vorrichtungen. Das Gehäuse-Baukastensystem weist ein Gehäuse mit einem in mindestens einer Baugröße ersten Gehäuseteil auf, mittels dem die Vorrichtung an der Tragschiene anbringbar ist. Außerdem weist das erste Gehäuseteil mindestens zwei Aufnahmeeinrichtungen für das Festlegen von jeweils einem Koppelmodul an dem ersten Gehäuseteil auf. Das Baukastensystem weist sowohl mindestens ein Koppelmodul zum Koppeln von Energieversorgungsleitungen als auch mindestens ein Koppelmodul zum Koppeln von Signalleitungen auf. An mindestens zwei, vorzugsweise beabstandet voneinander in dem ersten Gehäuseteil angeordneten Aufnahmeeinrichtungen ist entweder ein Koppelmodul zum Koppeln von Energieversorgungsleitungen zwischen zwei benachbart zueinander an der Tragschiene angeordneten Vorrichtungen festlegbar oder ein Koppelmodul zum Koppeln von Signalleitungen festlegbar.

In einer Ausführungsart weist das Gehäuse-Baukastensystem eine Vielzahl von unterschiedlichen Koppelmodulen für Energieversorgungsleitungen auf, beispielsweise sowohl Gleichspannungs- als auch zwei- oder mehrpolige Wechselspannungsversorgungsleitungen. Außerdem kann das Gehäuse-Baukastensystem mehrere Koppelmodule für unterschiedliche Spannungshöhen oder Stromhöhen aufweisen. In entsprechender Weise kann das Gehäuse-Baukastensystem auch unterschiedliche Koppelmodule für die Signalleitungen aufweisen, beispielsweise Koppelmodule für ein oder mehrere Zweidraht-Signalleitungen oder Koppelmodule für unterschiedliche Datenkommunikationsbusse. Weiterhin kann das Gehäuse-Baukastensystem auch Koppelmodule für optische Verbindungsleitungen aufweisen, beispielsweise für Glasfasern, wobei auch hier unterschiedliche Koppelmodule für unterschiedliche Faserdurchmesser oder eine unterschiedliche Anzahl von miteinander zu verbindenden Glasfaserleitungen vorgesehen sein können. Weiterhin kann das Gehäuse-Baukastensystem auch Koppelmodule für beispielsweise pneumatische Verbindungsleitungen aufweisen.

In einer Ausführungsart weist das Gehäuse-Baukastensystem sowohl Energieverbinderelemente, insbesondere elektrische Steckverbinder, zum Koppeln von Energieversorgungsleitungen als auch Signalverbinderelemente, insbesondere elektrische Steckverbinder, zum Koppeln von Signalleitungen auf. Die Verbinderelemente können dabei einpolig oder mehrpolig sein. In einer Ausführungsart sind die Energieverbinderelemente einpolig, wohingegen die Signalverbinderelemente mehrpolig sind, so dass damit mehrere und vorzugsweise alle zwischen zwei benachbart zueinander auf der Tragschiene angeordneten Vorrichtungen zu koppelnden Signalleitungen mit einem einzigen Signalverbinderelement verbindbar sind.

In einer Ausführungsart weist ein insbesondere mehrpoliges Verbinderelement in einem die Anschlussstellen zu den Koppelelementen der benachbarten Vorrichtungen überbrückenden Abschnitt eine Aussparung auf, in welche das erste Gehäuseteil oder ein mit dem ersten Gehäuseteil verbindbares zweites Gehäuseteil eingreift und dadurch die verbindende Position des Verbinderelements, insbesondere eine gesteckte Position eines mehrpoligen Verbinderelements, formschlüssig sichert. Die Verbindung kann dabei nicht nur gegen ein Lösen gesichert sein, sondern auch gegen eine gegenüber dem Lösen rechtwinklige Bewegung oder gegen ein Kippen des Verbinderelements. Dadurch ist die Betriebssicherheit der Vorrichtungen mit einem erfindungsgemäßen Gehäuse weiter erhöht.

In einer Ausführungsart weist mindestens ein Teil der Koppelmodule für die Energieversorgungsleitungen eine Isolationsfestigkeit von mindestens 230 V auf, insbesondere mindestens 380 V und vorzugsweise mindestens 500 V. Alternativ oder ergänzend weist mindestens ein Teil der Koppelmodule eine Stromtragfähigkeit von mindestens 5 A, insbesondere mindestens 10 A und vorzugsweise mindestens 16 A auf. Es ist besonders vorteilhaft, dass durch das Baukastensystem nur dort hochspannungsfähige oder hochstromtragfähige Koppelmodule eingesetzt werden müssen, wo dies aufgrund der Anwendung bzw. der in dem Gehäuse untergebrachten Komponenten erforderlich ist. Eine Anpassung kann erforderlichenfalls noch an der Montagestelle und insbesondere beim bereits montierten ersten Gehäuseteil erfolgen.

In einer Ausführungsart weist mindestens ein elektrischer Steckverbinder zum Stecken in ein Koppelmodul ein federelastisch verformbares, insbesondere gabelförmiges Kontaktorgan auf, das in eine Öffnung des zugeordneten Kontaktorgans des Koppelmoduls einsteckbar ist. Vorzugsweise weist das Kontaktorgan keine Fremdfeder auf. Durch die federelastische Verformbarkeit ist die Kontaktsicherheit erhöht. Im Falle einer Beeinträchtigung der Kontaktsicherheit, beispielsweise aufgrund einer Überbelastung oder mechanischen Beschädigung, kann auf einfache Weise der Steckverbinder ausgetauscht werden, wohingegen das Koppelmodul gegebenenfalls in dem ersten Gehäuseteil verbleiben kann oder im Bedarfsfall ebenfalls ausgetauscht werden kann, ohne dass das erste Gehäuseteil demontiert werden muss.

In einer Ausführungsart weist das Gehäuse-Baukastensystem weiterhin ein Einspeisegehäuseteil auf, das Einspeiseeinrichtungen für Energieversorgungsleitungen und/oder Einspeiseeinrichtungen für Signalleitungen aufweist. Darüber hinaus weist das Einspeisegehäuseteil mindestens ein Koppelmodul zum Koppeln von Energieversorgungsleitungen und/oder mindestens ein Koppelmodul zum Koppeln von Signalleitungen zu einer benachbart auf der Tragschiene angeordneten Vorrichtung auf. Dadurch kann beispielsweise im Abstand von einer vorgebbaren Anzahl von Vorrichtungen ein Einspeisegehäuseteil an der Tragschiene angeordnet werden, beispielsweise um bei Vorrichtungen mit hoher Leistungsaufnahme eine ausreichende Energieversorgung zu gewährleisten. Außerdem können durch die Auswahl einer geeigneten Einspeiseeinrichtung auch unterschiedliche Spannungsarten und Spannungsniveaus bereitgestellt werden, ebenso wie unterschiedliche Signalleitungen, beispielsweise unterschiedliche Datenbusse.

Die Erfindung betrifft auch eine Vorrichtung mit einem an einer Tragschiene anbringbaren Gehäuse, wobei das Gehäuse ein erstes Gehäuseteil aufweist, mittels dem die Vorrichtung an der Tragschiene anbringbar ist. Das erste Gehäuseteil weist mindestens zwei Aufnahmeeinrichtungen zum Festlegen von jeweils einem Koppelmodul an dem ersten Gehäuseteil auf. An mindestens zwei, vorzugsweise beabstandet voneinander in dem ersten Gehäuseteil angeordneten Aufnahmeeinrichtungen ist entweder ein Koppelmodul zum Koppeln von Energieversorgungsleitungen zwischen zwei benachbart zueinander an der Tragschiene angeordneten Vorrichtungen festgelegt, oder ein Koppelmodul zum Koppeln von Signalleitungen zwischen zwei benachbart zueinander an der Tragschiene angeordneten Vorrichtungen festgelegt. Zwei benachbart zueinander in dem ersten Gehäuseteil festgelegte Koppelmodule sind voneinander beabstandet.

In dem ersten Gehäuseteil können mindestens zwei oder sogar ausschließlich Koppelmodule für Energieversorgungsleitungen angeordnet sein oder mindestens zwei oder sogar ausschließlich Koppelmodule für Signalleitungen. Auch in diesem Fall ist es besonders vorteilhaft, wenn die benachbart zueinander in dem ersten Gehäuseteil festgelegten Koppelmodule voneinander beabstandet sind, weil dadurch mit hoher Sicherheit eine galvanische Trennung gewährleistet ist. Alternativ hierzu können in dem ersten Gehäuseteil sowohl mindestens ein Koppelmodul für Energieversorgungsleitungen als auch mindestens ein Koppelmodul für Signalleitungen festgelegt sein. In diesem Fall gewährleistet die Trennung der Koppelmodule und deren Abstand voneinander nicht nur eine sichere galvanische Trennung, sondern verhindert darüber hinaus auch noch ein störendes Beeinflussen der Signale bzw. Energieversorgung.

Insgesamt gewährleistet die vorliegende Erfindung eine besondere Modularität und Anpassungsfähigkeit des erfindungsgemäßen Tragschienengehäuses, insbesondere die einfache und zuverlässige Kopplung von Signal- oder Kommunikationsleitungen und Energieversorgungsleitungen. Das Gehäuse-Baukastensystem kann darüber hinaus auch erste Gehäuseteile in unterschiedlicher Baugröße umfassen, insbesondere erste Gehäuseteile mit unterschiedlicher Breite für die Aufnahme der in dem Gehäuse unterzubringenden Komponenten der Vorrichtung.

Weitere Vorteile, Merkmale und Einzelheiten der Erfindung ergeben sich aus den Unteransprüchen und der nachfolgenden Beschreibung, in der unter Bezugnahme auf die Zeichnungen mehrere Ausführungsbeispiel im Einzelnen beschrieben sind. Dabei können die in den Ansprüchen und in der Beschreibung erwähnten Merkmale jeweils einzeln für sich oder in beliebiger Kombination erfindungswesentlich sein.
- Fig. 1: zeigt eine perspektivische Ansicht auf an einer Tragschiene angebrachte und aneinander angereihte Vorrichtungen;
- Fig. 2: zeigt eine perspektivische Ansicht auf die Vorrichtungen der Fig. 1 mit abgenommenen zweiten Gehäuseteilen;
- Fig. 3: zeigt eine perspektivische Ansicht auf eine Vorrichtung mit von dem ersten Gehäuseteil abgenommenem zweiten Gehäuseteil;
- Fig. 4: zeigt eine perspektivische Ansicht auf die Vorrichtung der Fig. 3 mit auf dem ersten Gehäuseteil aufgesetztem zweiten Gehäuseteil;

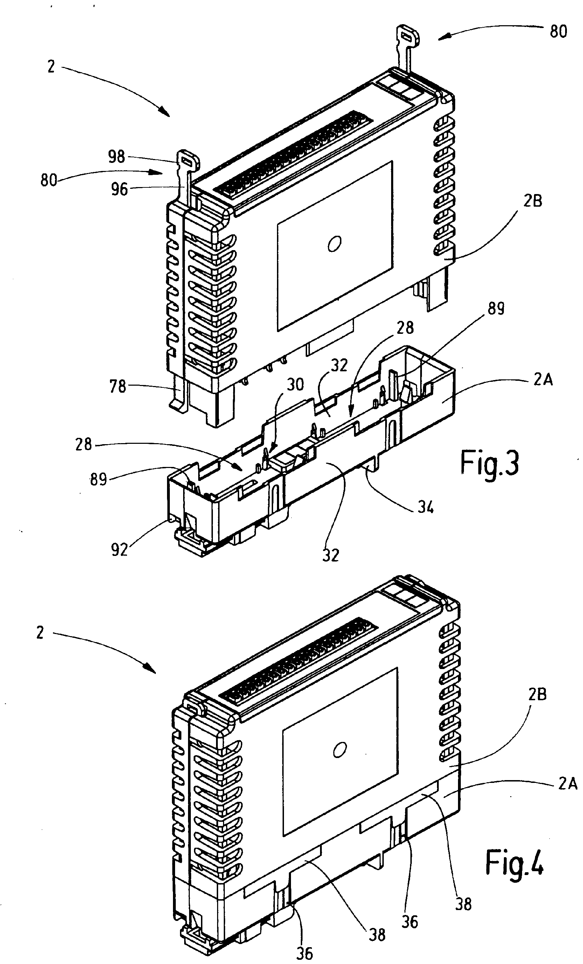

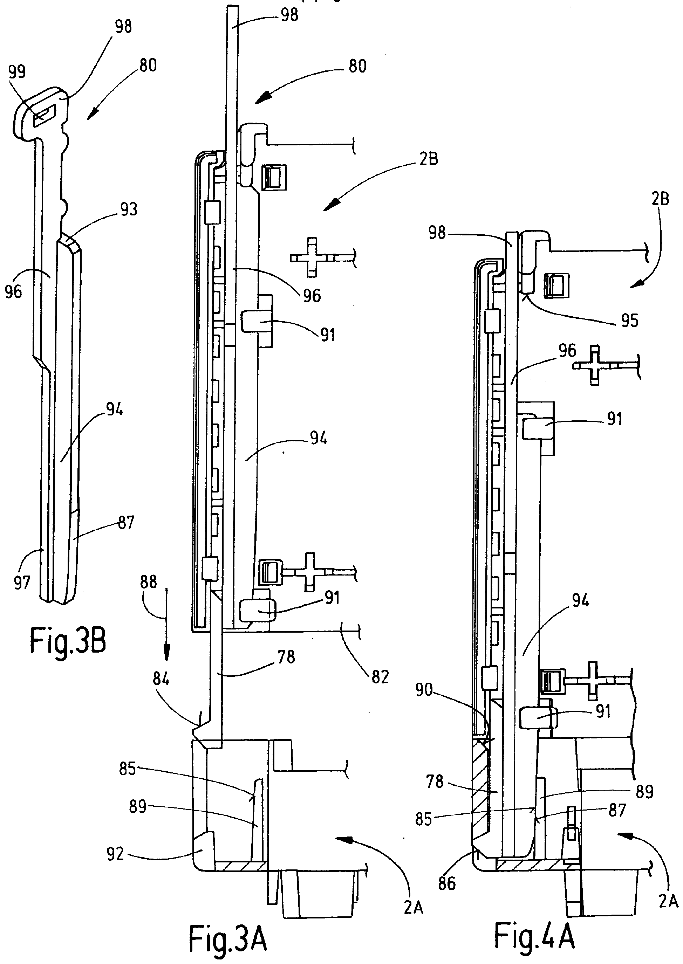

- Fig. 3A: zeigt in vergrößerter Darstellung einen Ausschnitt einer teilweise geschnittenen Seitenansicht des von dem ersten Gehäuseteil abgenommenem zweiten Gehäuseteils;
- Fig. 3B: zeigt eine perspektivische Ansicht eines in dem zweiten Gehäuseteil verschiebbar gelagerten Blockierelements;
- Fig. 4A: zeigt in vergrößerter Darstellung einen Ausschnitt einer teilweise geschnittenen Seitenansicht des auf dem ersten Gehäuseteil aufgesetzten zweiten Gehäuseteils;

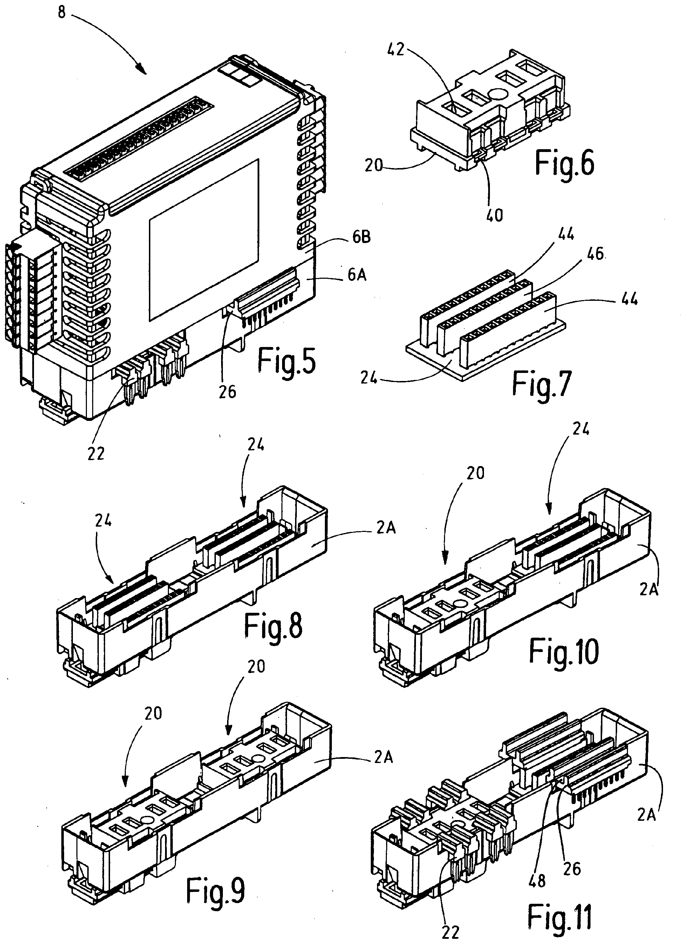

- Fig. 5: zeigt eine perspektivische Ansicht einer Vorrichtung mit eingesetzten Verbindungselementen;
- Fig. 6: zeigt eine perspektivische Ansicht auf ein Koppelmodul zum Koppeln von Energieversorgungsleitungen;
- Fig. 7: zeigt eine perspektivische Ansicht auf ein Koppelmodul zum Koppeln von Signalleitungen;
- Fig. 8: zeigt eine perspektivische Ansicht auf ein erstes Gehäuseteil, wobei in die beiden Aufnahmeeinrichtungen jeweils ein Koppelmodul zum Koppeln von Signalleitungen eingesetzt ist,
- Fig. 9: zeigt eine perspektivische Ansicht auf ein erstes Gehäuseteil mit zwei Koppelmodulen für Energieversorgungsleitungen;
- Fig. 10: zeigt eine perspektivische Ansicht auf ein erstes Gehäuseteil mit je einem Koppelmodul für Signal- und Energieversorgungsleitungen;
- Fig. 11: zeigt eine perspektivische Ansicht auf das erste Gehäuseteil der Fig. 10 mit eingesetzten Verbindungselementen;

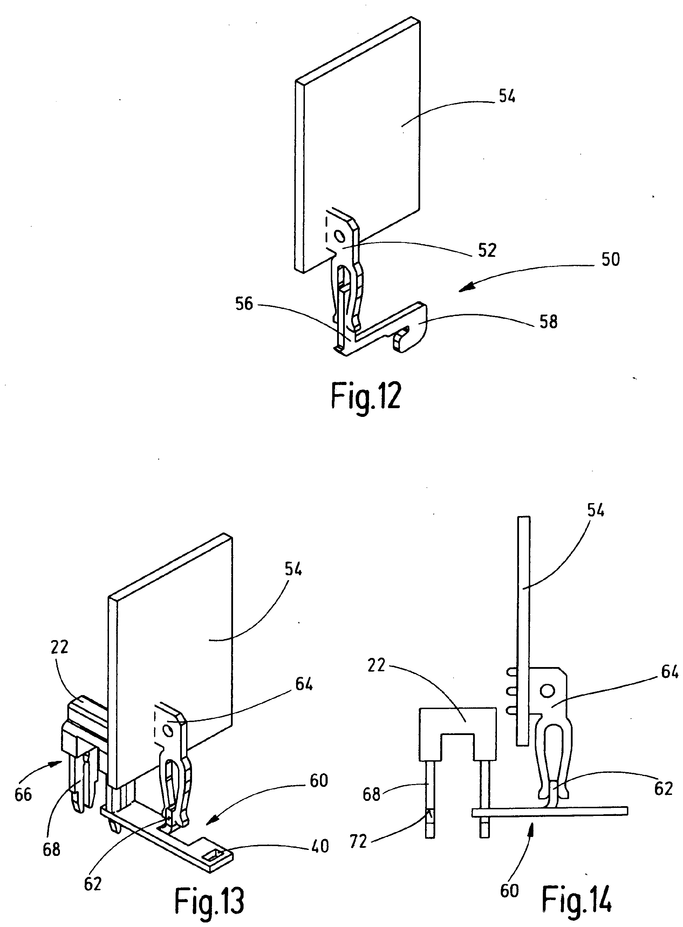

- Fig. 12: zeigt eine perspektivische Ansicht auf die Kontaktierung einer Schutzleiterelektrode;
- Fig. 13: zeigt eine perspektivische Ansicht auf ein Kontaktelement des Koppelmoduls für die Energieversorgungsleitungen; und
- Fig. 14: zeigt eine Seitenansicht auf die Anordnung der Fig. 13.

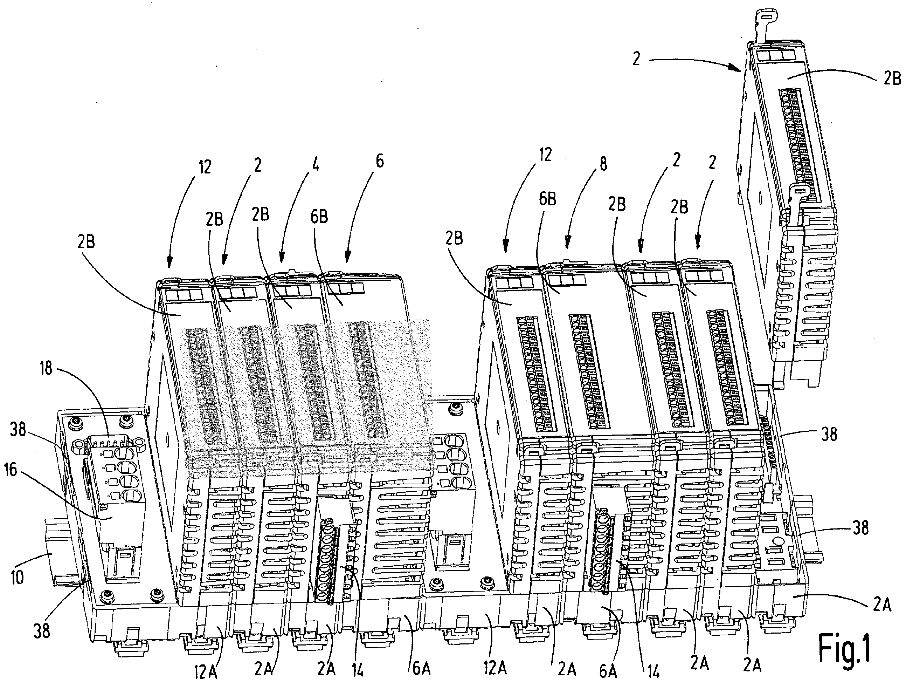

Die Fig. 1 zeigt eine perspektivische Ansicht auf an einer Tragschiene 10 angebrachte und aneinander angereihte Vorrichtungen 2, 4, 6, 8, 12. Es handelt sich dabei jeweils um elektrische Vorrichtungen mit jedenfalls teilweise unterschiedlicher Funktionalität.

Die Vorrichtungen 2, 4, 6, 8, 12 weisen eine übereinstimmende Höhe und Tiefe auf, unterscheiden sich jedoch teilweise in ihrer Breite. Gegenüber einer Vorrichtung 2 erster Bauart weist eine Vorrichtung 4 zweiter Bauart eine übereinstimmende Breite auf, allerdings ist an einer Seitenfläche eine Klemmleiste 14 angeordnet, an der beispielsweise elektrische oder optische Leitungen anschließbar sind. Eine Vorrichtung 6 dritter Bauart weist eine um etwa 50 % größere Breite auf. Eine Vorrichtung 8 vierter Bauart weist wiederum eine Klemmleiste 14 auf einer Seitenfläche auf. Bei den beiden Vorrichtungen fünfter Bauart handelt es sich um eine Einspeiseeinrichtungen 12, die eine Anschlussleiste 16 für den Anschluss von elektrischen Energieversorgungsleitungen aufweisen sowie eine Steckbuchse 18 für den Anschluss eines Signalleitungsbusses.

Die Vorrichtungen 2, 4, 6, 8, 12 weisen jeweils ein erstes Gehäuseteil 2A, 6A, 12A und ein hierzu passendes zweites Gehäuseteil 2B, 6B auf, das mit dem zugehörigen ersten Gehäuseteil 2A, 6A, 12A verbindbar ist, insbesondere auf dieses aufsteckbar und mit diesem verrastbar ist. Teilweise sind die zweiten Gehäuseteile 2B mit unterschiedlichen ersten Gehäuseteilen 2A, 12A kombinierbar. Die zweiten Gehäuseteile 2B können eine gegenüber dem ersten Gehäuseteil 12A unterschiedliche Breite aufweisen und dennoch miteinander zusammenfügbar sein.

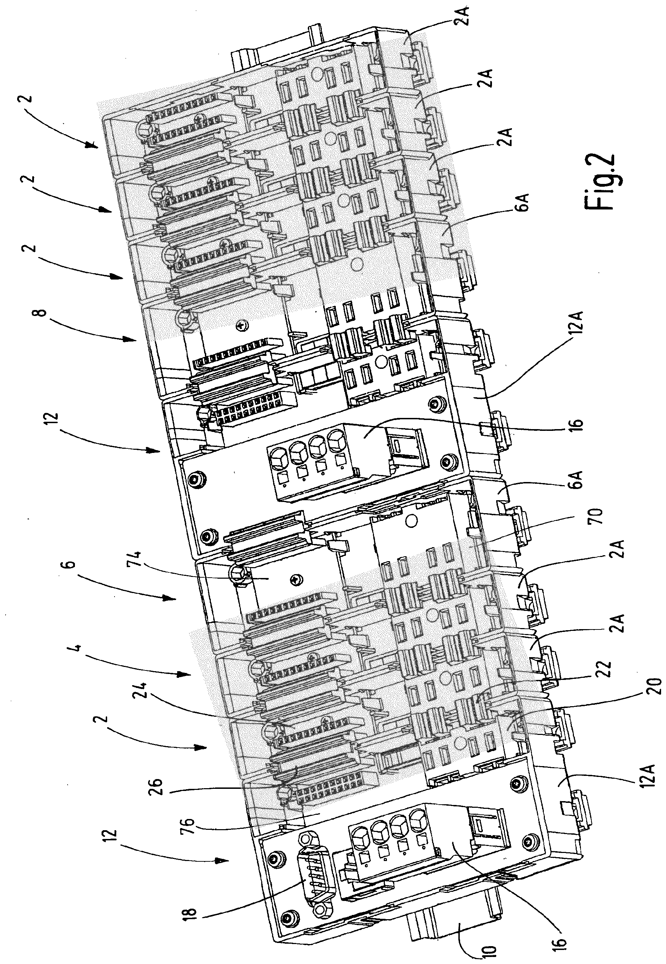

Die Fig. 2 zeigt eine perspektivische Ansicht auf die auf der Tragschiene 10 angebrachten Vorrichtungen 2, 4, 6, 8, 12 der Fig. 1 mit abgenommenen zweiten Gehäuseteilen 2B, 6B. In den ersten Gehäuseteilen 2A, 12A der Vorrichtungen 2, 4, 12 ist jeweils ein Koppelmodul 20 zum Koppeln von Energieversorgungsleitungen zwischen zwei benachbart zueinander an der Tragschiene 10 angeordneten Vorrichtungen 2, 4, 6, 8, 12 festgelegt. In den demgegenüber breiteren ersten Gehäuseteilen 6A der Vorrichtungen 6, 8 ist jeweils ein breiteres Koppelmodul 70 zum Koppeln von Energieversorgungsleitungen festgelegt.

Im Ausführungsbeispiel wird die vieradrige Energieversorgung ausgehend von der Anschlussleiste 16 über das Koppelmodul 20 von der Einspeiseeinrichtung 12 mittels insgesamt vier separat steckbaren und lösbaren Energieverbindungselementen 22 an die benachbart auf der Tragschiene 10 angeordnete Vorrichtung 2 erster Bauart übertragen und von dort in entsprechender Weise an die weiter angrenzenden Vorrichtungen 4 zweiter Bauart und die Vorrichtung 6 dritter Bauart. Durch den Einsatz unterschiedlich breiter Koppelmodule 20, 70 können einheitlich ausgebildete Energieverbindungselemente 22 für die Verbindung unterschiedlich breiter Vorrichtungen 2, 4, 6, 8, 12 eingesetzt werden.

Außerdem weist jedes erste Gehäuseteil 2A der Vorrichtungen 2, 4 ein Koppelmodul 24 zum Koppeln von Signalleitungen zwischen zwei benachbart zueinander an der Tragschiene 10 angeordneten Vorrichtung 2, 4, 6, 8, 12 auf. Die demgegenüber breiteren ersten Gehäuseteile 6A der Vorrichtungen 6, 8 weisen jeweils ein breiteres Koppelmodul 74 zum Koppeln von Signalleitungen auf. Das erste Gehäuseteil 12A der Einspeiseeinrichtungen 12 weist ein Koppelmodul 76 auf, das gegenüber den Koppelmodulen 24, 74 eine abweichende Anzahl der Kontakte für die in der Einspeiseeinrichtung 12 untergebrachte elektrische Einheit aufweist, insbesondere eine höhere Anzahl der Kontakte und vorzugsweise die doppelte Anzahl der Kontakte durch Verwendung einer doppelreihigen Anordnung.

Ausgehend von der Einspeiseeinrichtung 12 und der Steckbuchse 18 werden die Signalleitungen mittels eines mehrpoligen, im Ausführungsbeispiel elfpoligen, Signalverbinderelements 26 auf die Vorrichtung 2 erster Bauart übertragen und von dort anschließend weiter auf die Vorrichtung 4 zweiter Bauart und die Vorrichtung 6 dritter Bauart. Durch den Einsatz unterschiedlich breiter Koppelmodule 24, 74, 76 können einheitlich ausgebildete Signalverbinderelemente 26 für die Verbindung unterschiedlich breiter Vorrichtungen 2, 4, 6, 8, 12 eingesetzt werden. Anders als bei den Energieversorgungsleitungen werden die Signalleitungen außerdem auf die zweite Einspeiseeinrichtung 12 gekoppelt und von dort weiter auf die daran anschließenden Vorrichtungen 8, 2. Hinsichtlich der Energieeinspeisung erfolgt bei der zweiten Einspeiseeinrichtung 12 eine Neueinspeisung anhand der Anschlussleiste 16.

Die Abmessung der Koppelmodule 20, 24, 70, 74, 76 ist jeweils an die Größe des ersten Gehäuseteils 2A, 6A, 12A angepasst, insbesondere sind für unterschiedlich breite erste Gehäuseteile 2A, 6A, 12A entsprechend unterschiedlich breite Koppelmodule 20, 24, 70, 74, 76 vorgesehen.

Bei einem gewünschten oder erforderlichen Austausch einer oder mehrerer Vorrichtungen 2, 4, 6, 8, 12 kann das jeweilige zweite Gehäuseteil 2B, 6B mit der darin befindlichen elektronischen Baugruppe abgenommen und ausgetauscht werden, ohne dass die Energie- oder Signalverbindung zwischen den benachbarten Vorrichtungen 2, 4, 6, 8, 12 unterbrochen wird. Durch eine Trennung von Energie- und Signalversorgungsleitungen, etwa durch einzeln steckbare Energie- und Signalverbindungselemente 22, 26, kann auch die Signal- und/oder Energieverbindung aufrechterhalten werden und lediglich, gegebenenfalls auch nur teilweise, die Energie- bzw. Signalverbindung unterbrochen werden.

Die Fig. 3 zeigt eine perspektivische Ansicht auf die Vorrichtung 2 erster Bauart mit von dem ersten Gehäuseteil 2A abgenommenem zweiten Gehäuseteil 2B. Die Fig. 4 zeigt eine perspektivische Ansicht auf die Vorrichtung 2 mit auf dem ersten Gehäuseteil 2A aufgesetztem zweiten Gehäuseteil 2B. In der Darstellung der Fig. 3 sind noch keine Koppelmodule 20, 24 in das erste Gehäuseteil 2A eingesetzt. Dadurch sind die beiden Aufnahmeeinrichtungen 28 zur Aufnahme der Koppelmodule 20, 24 sichtbar. Jede Aufnahmeeinrichtung 28 umfasst insgesamt vier, einstückig von dem ersten Gehäuseteil 2A ausgebildete Rastelemente 30. Die Rastelemente 30 sind an den beiden einander gegenüberliegenden Seitenwänden 32 des ersten Gehäuseteils 2A angeordnet, die quer zur Längsachse der Tragschiene 10 verlaufen bzw. quer zu einer Längsachse einer von dem ersten Gehäuseteil 2A vorzugsweise einstückig ausgebildeten Aufnahme 34 für die Tragschiene 10.

Im Bereich der Aufnahmeeinrichtungen 28 sind die Seitenwände 32 für den Durchtritt der Energieverbindungselemente 22 bzw. Signalverbindungselemente 26 zinnenförmig abgesetzt. Für den in der Fig. 4 dargestellten Fall, dass keine solchen Verbindungselemente 22, 26 eingesetzt werden, sind vorzugsweise in eine auf der Außenseite der Seitenwände 32 eingebrachte Nut 36 Abdeckelemente 38 einsetzbar, vorzugsweise rastend und/oder werkzeuglos lösbar, um die zwischen den zinnenförmigen Absätzen des ersten Gehäuseteils 2A und der geradlinigen Gehäusekante des zweiten Gehäuseteils 2B vorhandenen Öffnungen abzudecken.

Die Abdeckelemente 38 können bei einer Aneinanderreihung von Vorrichtungen 2, 4, 6, 8, 12 (Fig. 1) einseitig an den stirnseitigen Enden der endseitigen Vorrichtungen 2, 12 eingesetzt sein, oder beidseitig im Falle einer einzelnen Vorrichtung 2, wie in der Fig. 4 dargestellt. Es können an einer Seite der Vorrichtung 2, 4, 6, 8, 12 auch nur teilweise Abdeckelemente 38 eingesetzt sein, beispielsweise wenn an der entsprechenden Stelle der Vorrichtung 2, 4, 6, 8, 12 keine Kopplung erforderlich ist, d.h. keine Energie- oder Signalverbindungselemente 22, 26 eingesetzt sind oder auch kein der Öffnung zugeordnetes Koppelmodul 20, 24, 70, 74 in dem ersten Gehäuseteil 2A, 6A, 12A festgelegt ist.

Die Fig. 3A zeigt in vergrößerter Darstellung einen Ausschnitt einer teilweise geschnittenen Seitenansicht des von dem ersten Gehäuseteil 2A abgenommenem zweiten Gehäuseteils 2B. Das zweite Gehäuseteil 2B bildet einstückig ein über das Ende seiner Gehäuseschale 82 hinaus ragendes und federnd auslenkbares Rastmittel 78 aus, das an seinem freien Ende eine Rastflanke 84 und eine Auflaufflanke 86 (Fig. 4A) aufweist. Die Rastflanke 84 schließt mit der Aufsteckrichtung 88, in welcher das zweite Gehäuseteil 2B auf das erste Gehäuseteil 2A aufsteckbar ist, einen größeren Winkel von im Ausführungsbeispiel zwischen 50 und 70° ein als die Auflaufflanke 86, die mit der Aufsteckrichtung 88 einen Winkel zwischen 30 und 50° einschließt.

Die Fig. 3B zeigt eine perspektivische Ansicht eines in dem zweiten Gehäuseteil 2B verschiebbar gelagerten Blockierelements 80. Die Fig. 4A zeigt in vergrößerter Darstellung einen Ausschnitt einer teilweise geschnittenen Seitenansicht des auf dem ersten Gehäuseteil 2A aufgesetzten zweiten Gehäuseteils 2B. Beim Aufstecken des zweiten Gehäuseteils 2B auf das erste Gehäuseteil 2A entsprechend dem Übergang von der Fig. 3 oder 3A zur Fig. 4 oder 4A wird zunächst das Rastmittel 78 gegenüber der Gehäuseschale 82 ausgelenkt, indem die Auflaufflanke 86 auf einer von dem ersten Gehäuseteil 2A ausgebildeten Auflaufschräge 90 aufläuft. Im zusammengesteckten Zustand der Fig. 4A rastet das Rastmittel 78 in eine im ersten Gehäuseteil 2A vorgesehene Rastöffnung 92 ein und schwenkt dabei in seine Ausgangsstellung zurück. In diesem Zustand kann das verschiebbar in dem zweiten Gehäuseteil 2B gelagerte Blockierelement 80 verschoben werden, so dass es in eine Anlage an das Rastmittel 78 kommt, durch welche ein Auslenken des Rastmittels 78 und damit ein Lösen der Verbindung der beiden Gehäuseteile 2A, 2B verhindert werden kann. Das zweite Gehäuseteil 2B weist auf seinen einander gegenüberliegenden Schmalseiten jeweils ein Rastmittel 78 und ein Blockierelement 80 auf.

Das Blockierelement 80 ist in dem in der Fig. 4A dargestellten, in das zweite Gehäuseteil 2B eingeführten Zustand in formschlüssiger Anlage an einem von dem zweiten Gehäuseteil 2B einstückig ausgebildeten Blockademittel 89, das zusätzlich zu der Eigensteifigkeit des Blockierelements 80 ein Auslenken des Blockierelements 80 und damit des Rastmittels 78 zuverlässig verhindert. Das Blockademittel 89 ist mit dem Boden und mit einer Seitenwand 32 des ersten Gehäuseteils 2A verbunden, wodurch es eine hohe Steifigkeit aufweist. Das Blockademittel 89 erstreckt sich über eine Länge, die mehr als 50 % der Höhe des ersten Gehäuseteils 2A beträgt. Das Blockademittel 89 und/oder das Blockierelement 80 weisen eine Anlaufschräge 85, 87 auf, durch welche das Einführen des Blockierelements 80 vereinfacht ist und auch eine Sicherung des eingeführten Zustandes des Blockierelements 80 durch eine leicht klemmende Anlage erreichbar ist.

Das Blockierelement 80 weist hierzu im Ausführungsbeispiel eine L-förmige Querschnittsform auf, wobei der im Bereich des dem Rastmittel 78 zugewandten Endes breitere erste Schenkel 94 in Anlage an von dem zweiten Gehäuseteil 2B, insbesondere der Gehäuseschale 82, vorzugsweise einstückig ausgebildeten Führungsmitteln 91 ist. An seinem dem Rastmittel 78 gegenüberliegenden Ende bildet der erste Schenkel 94 ein Mitnehmermittel 93 aus, das in dem in der Fig. 3A dargestellten Zustand in Anlage an einem von dem zweiten Gehäuseteil 2B vorzugsweise einstückig ausgebildeten Stoppmittel 95 ist. Dadurch ist das Blockierelement 80 zum einen unverlierbar an dem zweiten Gehäuseteil 2B angeordnet und zum anderen kann dadurch das zweite Gehäuseteil 2B durch Ziehen an dem Blockierelement 80 von dem ersten Gehäuseteil 2A abgezogen und anschließend abgenommen werden.

Der zweite Schenkel 96 des Blockierelements 80 erstreckt sich im Ausführungsbeispiel rechtwinklig zum ersten Schenkel 94 und bildet an einem Ende die Anlagefläche 97 für das Rastmittel 78 aus. An seinem gegenüberliegenden Ende bildet das Blockierelement 80 und insbesondere der zweite Schenkel 96 ein Griffstück 98 aus, welches zur Handhabe des Blockierelements 80 dient und auch in der in der Fig. 4A dargestellten, den zusammengesteckten Zustand sichernden Position des Blockierelements 80 zugänglich ist. Zur vereinfachten Betätigung weist das Blockierelement 80 insbesondere im Bereich des Griffstücks 98 eine Werkzeugangriffsfläche 99 auf, im Ausführungsbeispiel eine Öffnung oder Vertiefung zum Einsetzen eines Schlitz-Schraubendrehers. Die Betätigung des Blockierelements 80 kann werkzeuglos erfolgen. In der in der Fig. 4A dargestellten, den zusammengesteckten Zustand sichernden Position des Blockierelements 80 schließt dieses endseitig im Wesentlichen bündig mit dem zweiten Gehäuseteil 2B, insbesondere einer Gehäuseschale 82 des zweiten Gehäuseteils 2B, ab, um ein unbeabsichtigtes Betätigen des Blockierelements 80 zu vermeiden.

Die Fig. 5 zeigt eine perspektivische Ansicht der Vorrichtung 8 dritter Bauart mit insgesamt vier eingesetzten Energieverbindungselementen 22 und einem eingesetzten Signalverbindungselement 26. Durch die Montage des zweiten Gehäuseteils 6B auf dem ersten Gehäuseteil 6A kommt es durch eine Anlage der Kante des zweiten Gehäuseteils 6B an den Energie- und Signalverbindungselementen 22, 26 formschlüssig zu einem vollständigen Einstecken der Energie- und Signalverbindungselemente 22, 26 in die Koppelmodule 20, 24 und zu einer Sicherung des vollständig eingesteckten Zustandes.

Die Fig. 6 zeigt eine perspektivische Ansicht auf ein Koppelmodul 20 zum Koppeln von Energieversorgungsleitungen, das für eine Betriebsspannung von 230 V oder mehr ausgelegt ist. Die im Betrieb gegebenenfalls spannungsführenden Teile sind entweder unmittelbar durch das Koppelmodul 20 selbst oder im eingebauten Zustand im Zusammenspiel mit dem ersten Gehäuseteil 2A berührungssicher angeordnet. Das insgesamt vierpolige Koppelelement 20 weist an seinen einander gegenüberliegenden Längsrändern jeweils insgesamt vier Anschlussstellen 40 auf, insbesondere Steckkontakte, zum Koppeln der Energieversorgungsleitungen zu einer benachbart an der Tragschiene 10 angeordneten Vorrichtung mittels jeweils eines Energieverbindungselements 22 (Fig. 5). Zwischen einander gegenüberliegenden Anschlussstellen 40, insbesondere mittig, weist das Koppelmodul 20 jeweils eine weitere Anschlussstelle 42 auf, insbesondere einen weiteren Steckkontakt, für die im Gehäuse, insbesondere im zweiten Gehäuseteil 6B, angeordneten elektrischen Komponenten der Vorrichtung 8. Das breitere Koppelmodul 70 kann demgegenüber die weiteren Anschlussstellen außermittig aufweisen. Das Koppelmodul 20 kann symmetrisch zu einer Mittelebene aufgebaut sein und kann dadurch in unterschiedlichen Ausrichtungen in das erste Gehäuseteil 6A eingesetzt werden.

Die Fig. 7 zeigt eine perspektivische Ansicht auf das Koppelmodul 24 zum Koppeln von Signalleitungen. Das Koppelmodul 24 weist entlang seiner Längsseiten nahe des Randes jeweils eine mehrpolige, im Ausführungsbeispiel elfpolige Anschlussleiste 44 für die Kopplung der Signalleitungen zu den benachbarten Vorrichtungen auf. Zwischen den randseitigen Anschlussleisten 44 weist das Koppelmodul 24, im Ausführungsbeispiel außermittig, eine weitere Anschlussleiste 46 für die im Gehäuse, insbesondere im zweiten Gehäuseteil 6B, angeordneten Komponenten der Vorrichtung 8 auf.

Die Fig. 8 zeigt eine perspektivische Ansicht auf ein erstes Gehäuseteil 2A, wobei in die beiden Aufnahmeeinrichtungen 28 jeweils ein Koppelmodul 24 zum Koppeln von Signalleitungen eingesetzt ist. Die Fig. 9 zeigt eine perspektivische Ansicht auf ein erstes Gehäuseteil 2A, wobei in die beiden Aufnahmeeinrichtungen 28 jeweils ein Koppelmodul 20 zum Koppeln von Energieversorgungsleitungen eingesetzt ist. Die Fig. 10 zeigt eine perspektivische Ansicht auf ein erstes Gehäuseteil 2A, in das ein Koppelmodul 24 zum Koppeln von Signalleitungen und ein Koppelmodul 20 zum Koppeln von Energieversorgungsleitungen eingesetzt sind.

Die Fig. 11 zeigt eine perspektivische Ansicht auf das erste Gehäuseteil 2A der Fig. 10, wobei in das Koppelmodul 20 auf jeder Seite insgesamt vier Energieverbindungselemente 22 eingesetzt sind und in das Koppelmodul 24 auf jeder Seite ein mehrpoliges Signalverbindungselement 26 eingesetzt ist. Das mehrpolige Signalverbindungselement 26 weist in dem die randseitigen Anschlussstellen 44 bzw. Anschlussleisten der benachbarten Vorrichtungen überbrückenden Abschnitt eine sich in Längsrichtung erstreckende Aussparung 48 auf, insbesondere eine im Querschnitt im Wesentlichen U-förmige Nut, in welche das zweite Gehäuseteil 6B mit seinem Gehäuserand eingreift (Fig. 5), und dadurch die verbindende Position des Signalverbinderelements 26 formschlüssig sichert.

Die Fig. 12 zeigt eine perspektivische Ansicht auf die Kontaktierung einer Schutzleiterelektrode 50 durch einen Platinenanschluss 52 einer in der Vorrichtung 8 angeordneten Platine 54. Die Schutzleiterelektrode 50 ragt dabei mit ihrem dem Platinenanschluss 52 zugewandten freien Ende vorzugsweise zwischen zwei Aufnahmeeinrichtungen 28 zum Festlegen der Koppelmodule 20, 24, 70, 74 in das erste Gehäuseteil 2A, 6A, 12A hinein. Mit dem hakenförmigen Abschnitt 58 ragt die Schutzleiterelektrode 50 aus dem ersten Gehäuseteil 6A heraus und kommt bei Aufsetzen der Vorrichtung 8 auf die Tragschiene 10 in unmittelbaren elektrisch leitfähigen Kontakt, beispielsweise klemmend, schneidend oder federnd, mit der Tragschiene 10, die ihrerseits geerdet ist. Dadurch ist ein Erdanschluss bzw. Schutzleiteranschluss der Platine 54 unmittelbar durch das Aufsetzen der Vorrichtung 8 auf die Tragschiene 10 gewährleistet.

Die Fig. 13 zeigt eine perspektivische Ansicht auf ein Kontaktelement 60 des Koppelmoduls 20 für die Energieversorgungsleitungen. Die Fig. 14 zeigt eine Seitenansicht auf die Anordnung der Fig. 13. Das Kontaktelement 60 ist ein flächiges Stanz-/Biegeteil, aus dessen Fläche eine Kontaktnase 62 für den Platinenanschluss 64 abgebogen ist. An seinen einander gegenüberliegenden Enden weist das Kontaktelement 60 jeweils eine Anschlussstelle 40 auf, in welche jeweils ein Energieverbinderelement 22 einsteckbar ist. Das Energieverbinderelement 22 weist ein federelastisch verformbares, insbesondere gabelförmiges Kontaktorgan 66 mit zwei Federkontaktschenkeln 68 auf, die in die Öffnung der Anschlussstelle 40 einsteckbar sind. Die Kontaktschenkel 68 weisen dabei an einem Übergang zu einem verjüngten freien Endabschnitt einen vorzugsweise rechtwinkligen Absatz 72 auf, der einen Anschlag beim Einsetzen des Energieverbindungselements 22 in die Anschlussstelle 40 bildet.

Der Platinenanschluss 52 für die Schutzleiterelektrode 50 und der Platinenanschluss 64 für das Kontaktelement 60 des Koppelmoduls 20 können Gleichteile sein, was sowohl fertigungstechnisch als auch hinsichtlich der Montagesicherheit und Betriebssicherheit vorteilhaft ist. Durch eine unterschiedliche Anordnung der Platinenanschlüsse 52, 64 auf der Platine 54, insbesondere einem unterschiedlichen Abstand vom Rand der Platine 54, und/oder durch eine unterschiedliche Länge des freien Endes 56 einerseits und der Kontaktnase 62 andererseits kann auch bei der Verwendung von Gleichteilen für die Platinenanschlüsse 52, 64 sichergestellt sein, welcher Kontakt voreilend ist, insbesondere kann sichergestellt sein, dass beim Aufsetzen der Platine 54 zuerst die Verbindung zwischen dem Platinenanschluss 52 und der Schutzleiterelektrode 50 herstellbar ist und erst anschließend die Verbindung zwischen dem Platinenanschluss 64 und dem Kontaktelement 60 herstellbar ist.

## Patentansprüche

1. Gehäuse für an einer Tragschiene (10) anbringbare und aneinander anreihbare Vorrichtungen (2, 4, 6, 8, 12), insbesondere Reihenelektronikgehäuse, wobei das Gehäuse ein erstes Gehäuseteil (2A, 6A, 12A) aufweist, mittels dem die Vorrichtung (2, 4, 6, 8, 12) an der Tragschiene (10) anbringbar ist, wobei das erste Gehäuseteil (2A, 6A, 12A) mindestens zwei Aufnahmeeinrichtungen (28) zum Festlegen von jeweils einem Koppelmodul (20, 24, 70, 74) an dem ersten Gehäuseteil (2A, 6A, 12A) aufweist, und wobei an den mindestens zwei, vorzugsweise beabstandet voneinander in dem ersten Gehäuseteil (2A, 6A, 12A) angeordneten Aufnahmeeinrichtungen (28) entweder ein Koppelmodul (20, 70) zum Koppeln von Energieversorgungsleitungen zwischen zwei benachbart zueinander an der Tragschiene angeordneten Vorrichtungen (2, 4, 6, 8, 12) festlegbar ist oder ein Koppelmodul (24, 74) zum Koppeln von Signalleitungen zwischen zwei benachbart zueinander an der Tragschiene angeordneten Vorrichtungen (2, 4, 6, 8, 12) festlegbar ist, wobei das Gehäuse ein zweites Gehäuseteil (2b, 6b) aufweist, wobei das zweite Gehäuseteil (2b, 6b) mit dem ersten Gehäuseteil (2a, 6a, 12a) mittels eines elastisch auslenkbaren Rastmittels (78) lösbar verbindbar ist, **dadurch gekennzeichnet, dass** die Auslenkung des Rastmittels (78) durch ein beweglich am zweiten Gehäuse¬teil (2b, 6b) gelagertes Blockierelement (80) blockierbar ist und dadurch der mit dem ersten Gehäuseteil (2a, 6a, 12a) verbundene Zustand des zweiten Gehäuseteils (2b, 6b) sicherbar ist, und dass das Blockierelement (80) in dem zweiten Gehäuseteil (2b) verschiebbar gelagert ist.

2. Gehäuse nach Anspruch 1, **dadurch gekennzeichnet, dass** an mindestens einer der Aufnahmeeinrichtungen (28), vorzugsweise an allen Aufnahmeeinrichtungen (28), des ersten Gehäuseteils (2A, 6A, 12A) das zugehörige Koppelmodul (20, 24, 70, 74) lösbar, insbesondere werkzeuglos lösbar, festlegbar ist.

3. Gehäuse nach Anspruch 1 oder 2, **dadurch gekennzeichnet, dass** mindestens eine, vorzugsweise alle Aufnahmeeinrichtungen (28) mindestens ein Rastelement (30) aufweist, mit dem das Koppelmodul (20, 24, 70, 74) beim Festlegen an dem ersten Gehäuseteil (2A, 6A, 12A) in Eingriff bringbar ist, und dass mindestens ein Teil der Rastelemente (30) integral von den Seitenwänden (32) des ersten Gehäuseteils (2A, 6A, 12A) ausgebildet ist, die quer zur Längsachse der Tragschiene (10) verlaufen oder quer zu einer Längsachse einer von dem ersten Gehäuseteil (2A, 6A, 12A) vorzugsweise einstückig ausgebildeten Aufnahme (34) für die Tragschiene (10) verlaufen.

4. Gehäuse nach einem der vorangehenden Ansprüche, **dadurch gekennzeichnet, dass** in mindestens einer der Aufnahmeeinrichtungen (28) ein Koppelmodul (20, 24, 70, 74) festlegbar ist, mit dem mindestens eine Signalleitung, vorzugsweise mehrere Signalleitungen, zwischen zwei benachbart zueinander an der Tragschiene (10) angeordneten Vorrichtungen (2, 4, 6, 8, 12) koppelbar ist.

5. Gehäuse nach einem der vorangehenden Ansprüche, **dadurch gekennzeichnet, dass** mindestens eines der in dem ersten Gehäuseteil (2A, 6A, 12A) festgelegten Koppelmodule (20, 24, 70, 74) an oder nahe seinen einander gegenüberliegenden Rändern jeweils Anschlussstellen (40, 44), insbesondere Steckkontakte, aufweist zum Koppeln von Signal- oder Energieversorgungsleitungen zu einer benachbart an der Tragschiene (10) angeordneten Vorrichtung (2, 4, 6, 8, 12) mittels eines vorzugsweise steckbaren Verbindungselements (22, 26), und dass zwischen den Anschlussstellen, die den benachbart an der Tragschiene angeordneten Vorrichtungen (2, 4, 6, 8, 12) zugeordnet sind, das Koppelmodul (20, 24, 70, 74) mindestens eine weitere Anschlussstelle, insbesondere mindestens einen weiteren Steckkontakt, für im Gehäuse angeordnete Komponenten der Vorrichtung (2, 4, 6, 8, 12) aufweist.

6. Gehäuse-Baukastensystem für an einer Tragschiene (10) anbringbare und aneinander anreihbare Vorrichtungen (2, 4, 6, 8, 12), wobei das Gehäuse-Baukastensystem ein Gehäuse gemäß einem der Ansprüche 1 bis 5 mit einem in mindestens einer Baugröße ersten Gehäuseteil (2A, 6A, 12A) aufweist, mittels dem die Vorrichtung (2, 4, 6, 8, 12) an der Tragschiene (10) anbringbar ist, wobei das Gehäuse-Baukastensystem sowohl mindestens ein Koppelmodul (20, 70) zum Koppeln von Energieversorgungsleitungen als auch mindestens ein Koppelmodul (24, 74) zum Koppeln von Signalleitungen aufweist, und wobei an mindestens zwei, vorzugsweise beabstandet voneinander in dem ersten Gehäuseteil (2A, 6A, 12A) angeordneten Aufnahmeeinrichtungen (28) entweder ein Koppelmodul (20, 70) zum Koppeln von Energieversorgungsleitungen zwischen zwei benachbart zueinander an der Tragschiene (10) angeordneten Vorrichtungen (2, 4, 6, 8, 12) festlegbar ist oder ein Koppelmodul (24, 74) zum Koppeln von Signalleitungen zwischen zwei benachbart zueinander an der Tragschiene (10) angeordneten Vorrichtungen (2, 4, 6, 8, 12) festlegbar ist.

7. Gehäuse-Baukastensystem nach Anspruch 6, **dadurch gekennzeichnet, dass** das Gehäuse-Baukastensystem weiterhin sowohl Energieverbinderelemente (22), insbesondere elektrische Steckverbinder, zum Koppeln von Energieversorgungsleitungen als auch Signalverbinderelemente (26), insbesondere elektrische Steckverbinder, zum Koppeln von Signalleitungen aufweist.

8. Gehäuse-Baukastensystem nach Anspruch 7, **dadurch gekennzeichnet, dass** mindestens ein Energieverbinderelement (22) und/oder Signalverbinderelement (26) mehrpolig ist, so dass damit mehrere und vorzugsweise alle zwischen zwei benachbart zueinander an der Tragschiene (10) angeordneten Vorrichtungen (2, 4, 6, 8, 12) zu koppelnden Energieversorgungsleitungen und/oder Signalleitungen verbindbar sind.

9. Gehäuse-Baukastensystem nach Anspruch 8, **dadurch gekennzeichnet, dass** das mehrpolige Energieverbinderelement (22) und/oder Signalverbinderelement (26) in einem die Anschlussstellen zu den Koppelelementen der benachbarten Vorrichtungen (2, 4, 6, 8, 12) überbrückenden Abschnitt eine Aussparung (48) aufweist, in welche das erste Gehäuseteil (2A, 6A, 12A) oder das mit dem ersten Gehäuseteil (2A, 6A, 12A) verbindbare zweite Gehäuseteil (2B, 6B) eingreift und dadurch die verbindende Position des Energieverbinderelements (22) und/oder Signalverbinderelements (26), insbesondere eine gesteckte Position eines mehrpoligen Steckverbinders, formschlüssig sichert.

10. Gehäuse-Baukastensystem nach einem der Ansprüche 6 bis 9, **dadurch gekennzeichnet, dass** mindestens ein Teil der Koppelmodule (20, 24, 70, 74) für die Energieversorgungsleitungen eine Isolationsfestigkeit von mindestens 230 V aufweist, insbesondere mindestens 380 V und vorzugsweise mindestens 500 V, und/oder eine Stromtragfähigkeit von mindestens 5 A, insbesondere mindestens 10 A und vorzugsweise mindestens 16 A.

11. Gehäuse-Baukastensystem nach einem der Ansprüche 7 bis 10, **dadurch gekennzeichnet, dass** mindestens ein elektrischer Steckverbinder zum Stecken in ein Koppelmodul (20, 24, 70, 74) ein federelastisch verformbares, insbesondere gabelförmiges Kontaktorgan (66) aufweist, das in eine Öffnung des Kontaktelements (60) des Koppelmoduls (20, 70) einsteckbar ist.

12. Gehäuse-Baukastensystem nach einem der Ansprüche 6 bis 11, **dadurch gekennzeichnet, dass** das Gehäuse-Baukastensystem weiterhin ein Einspeisegehäuseteil (12) aufweist, das Einspeiseeinrichtungen (16) für Energieversorgungsleitungen und/oder Einspeiseeinrichtungen (18) für Signalleitungen aufweist, und darüber hinaus mindestens ein Koppelmodul (20, 70) zum Koppeln von Energieversorgungsleitungen und/oder mindestens ein Koppelmodul (24, 74) zum Koppeln von Signalleitungen zu einer benachbart an der Tragschiene (10) angeordneten Vorrichtung (2, 4, 6, 8, 12) aufweist.

13. Vorrichtung (2, 4, 6, 8, 12) mit einem an einer Tragschiene (10) anbringbaren Gehäuse gemäß einem der Ansprüche 1 bis 5, wobei an den mindestens zwei, vorzugsweise beabstandet voneinander in dem ersten Gehäuseteil (2A, 6A, 12A) angeordneten Aufnahmeeinrichtungen (28) entweder ein Koppelmodul (20, 70) zum Koppeln von Energieversorgungsleitungen zwischen zwei benachbart zueinander an der Tragschiene (10) angeordneten Vorrichtungen (2, 4, 6, 8, 12) festgelegt ist oder ein Koppelmodul (24, 74) zum Koppeln von Signalleitungen zwischen zwei benachbart zueinander an der Tragschiene (10) angeordneten Vorrichtungen (2, 4, 6, 8, 12) festgelegt ist, und wobei zwei benachbart zueinander in dem ersten Gehäuseteil (2A, 6A, 12A) festgelegte Koppelmodule (20, 24, 70, 74) beabstandet voneinander sind.

14. Vorrichtung (2, 4, 6, 8, 12) nach Anspruch 13, **dadurch gekennzeichnet, dass** in mindestens einer der Aufnahmeeinrichtungen (28) ein Koppelmodul (20, 24, 70, 74) festgelegt ist, mit dem mindestens eine Signalleitung, insbesondere eine elektrische Signalleitung und vorzugsweise mehrere elektrische Signalleitungen, zwischen zwei benachbart zueinander an der Tragschiene (10) angeordneten Vorrichtungen (2, 4, 6, 8, 12) koppelbar ist.

## Claims

1. Casing for devices (2, 4, 6, 8, 12) mounted side by side on a rail (10), especially a series-manufactured electronic casing, wherein the casing comprises a first casing part (2A, 6A, 12A), by means of which the device (2, 4, 6, 8, 12) can be mounted on the rail (10), wherein the first casing part (2A, 6A, 12A) comprises at least two mounting devices (28) for fixing each respective coupling module (20, 24, 70, 74) to the first casing part (2A, 6A, 12A), and wherein either a coupling module (20, 70) for coupling energy supply cables between two devices (2, 4, 6, 8, 12) arranged adjacent to each other on the rail or a coupling module (24, 74) for coupling signal cables between two devices (2, 4, 6, 8, 12) can be fixed to the at least two mounting devices (28), preferably spaced apart from one another in the first casing part (2A, 6A, 12A), wherein the second casing comprises a second casing part (2b, 6b), wherein the second casing part (2b, 6b) can be detachably connected to the first casing part (2a, 6a, 12a) by an elastically deflectable latching means (78), **characterised in that** deflection of the latching means (78) can be blocked by a blocking element (80) mounted on the second casing part (2b, 6b) such that it can move, thus securing the connected status of the second casing part (2b, 6b) to the first casing part (2a, 6a, 12a), and **in that** the blocking element (80) is mounted in the second casing part (2b) such that it can be displaced.

2. Casing according to claim 1, **characterised in that** the associated coupling module (20, 24, 70, 74) can be detachably, preferably detachably without the use of tools, fixed on at least one of the mounting devices (28), preferably on all mounting devices (28), of the first casing part (2A, 6A, 12A).

3. Casing according to either claim 1 or claim 2, **characterised in that** at least one, preferably all mounting devices (28), comprises at least one latching element (30), with which the coupling module (20, 24, 70, 74) can be engaged when fixing to the first casing part (2A, 6A, 12A), and **in that** at least one portion of the latching elements (30) is designed as an integral part of the side walls (32) of the first casing part (2A, 6A, 12A), which run transversely with respect to the longitudinal axis of the rail (10) or transversely with respect to a longitudinal axis of a mount (34) for the rail (10), said mount preferably being designed in one piece with the first casing part (2A, 6A, 12A).

4. Casing according to any one of the preceding claims, **characterised in that** a coupling module (20, 24, 70, 74) can be fixed in at least one of the mounting devices (28), at least one signal cable, preferably a plurality of signal cables, being able to be coupled with said coupling module between two devices ((2, 4, 6, 8, 12) arranged adjacent to one another on the rail (10).

5. Casing according to any one of the preceding claims, **characterised in that** at least one of the coupling modules (20, 24, 70, 74) fixed in the first casing part (2A, 6A, 12A) comprises respective connection points (40, 44), especially plug-in contacts, on or near its opposite edges for coupling signal or energy supply cables to a device (2, 4, 6, 8, 12) arranged adjacently on the rail (10) by means of a preferably plug-in-type connecting element (22, 26), and **in that** the coupling module (20, 24, 70, 74) comprises at least one additional connection point between the connection points assigned to the devices (2, 4, 6, 8, 12) arranged adjacently on the rail, especially at least one additional plug-in contact for components of the device (2, 4, 6, 8, 12) arranged in the casing.

6. Modular casing system for devices (2, 4, 6, 8, 12) mounted side by side on a rail (10), wherein the modular casing system comprises a casing according to any one of claims 1 to 5 with a first casing part (2A, 6A, 12A) in at least one frame size, by means of which the device (2, 4, 6, 8, 12) can be mounted on the rail (10), wherein the modular casing system comprises both at least one coupling module (20, 70) for coupling energy supply cables and at least one coupling module (24, 74) for coupling signal cables, and wherein either a coupling module (20, 70) for coupling energy supply cables between two devices (2, 4, 6, 8, 12) arranged adjacent to one another on the rail (10) or a coupling module (24, 74) for coupling signal cables between two devices (2, 4, 6, 8, 12) arranged adjacent to one another on the rail (10) can be fixed on at least two mounting devices (28), preferably spaced apart from one another in the first casing part (2A, 6A, 12A).

7. Modular casing system according to claim 6, **characterised in that** the modular casing system also comprises both energy connection elements (22), especially electrical plug connectors, for coupling energy supply cables, and signal connection elements (26), especially electrical plug connectors, for coupling signal cables.

8. Modular casing system according to claim 7, **characterised in that** at least one energy connection element (22) and/or signal connection element (26) has multiple poles such that a plurality of and preferably all energy supply cables and/or signal cables to be coupled between two devices (2, 4, 6, 8, 12) arranged adjacent to one another on the rail (10) can be connected by this means.

9. Modular casing system according to claim 8, **characterised in that** the multi-pole energy connection element (22) and/or signal connection element (26) in a section bridging the connection points to the coupling elements of the adjacent devices (2, 4, 6, 8, 12) comprises a recess (48), in which the first casing part (2A, 6A, 12A) or the second casing part (2B, 6B), which can be connected to the first casing part (2A, 6A, 12A), engages, thus positively securing the connecting position of the energy connection element (22) and/or signal connection element (26), especially a plugged-in position of a multi-pole plug-in connector.

10. Modular casing system according to any one of claims 6 to 9, **characterised in that** at least some of the coupling modules (20, 24, 70, 74) for the energy supply cables have an insulation strength of at least 230 V, especially at least 380 V and preferably at least 500 V, and/or a current-carrying capacity of at least 5 A, especially at least 10 A and preferably at least 16 A.

11. Modular casing system according to any one of claims 7 to 10, **characterised in that** at least one electrical plug connector for plugging into a coupling module (20, 24, 70, 74) comprises a resiliently sprung, deformable, especially forked contact organ (66), which can be plugged into an opening in the contact element (60) of the coupling module (20, 70).

12. Modular casing system according to any one of claims 6 to 11, **characterised in that** the modular casing system also comprises a feed-in casing part (12), which comprises feed-in devices (16) for energy supply cables and/or feed-in devices (18) for signal cables, and also at least one coupling module (20, 70) for coupling energy supply cables and/or at least one coupling module (24, 74) for coupling signal cables to a device (2, 4, 6, 8, 12) arranged adjacently on the rail (10).

13. Device (2, 4, 6, 8, 12) with a casing that can be mounted on a rail (10) according to any one of claims 1 to 5, wherein either a coupling module (20, 70) for coupling energy supply cables between two devices (2, 4, 6, 8, 12) arranged adjacent to one other on the rail (10) or a coupling module (24, 74) for coupling signal cables between two devices (2, 4, 6, 8, 12) arranged adjacent to one another on the rail (10) is fixed to the at least two mounting devices (28), preferably spaced apart from one another in the first casing part (2A, 6A, 12A), and two coupling modules (20, 24, 70, 74) fixed adjacent to one another in the first casing part (2A, 6A, 12A) are spaced apart from one another.

14. Device (2, 4, 6, 8, 12) according to claim 13, **characterised in that** a coupling module (20, 24, 70, 74) is fixed in at least one of the mounting devices (28), at least one signal cable, especially one electrical signal cable and preferably a plurality of signal cables, being able to be coupled with said coupling module between two devices ((2, 4, 6, 8, 12) arranged adjacent to one another on the rail (10).

## Revendications

1. Boîtier pour des appareils (2, 4, 6, 8, 12) pouvant être montés et rangés les uns à côté des autres sur un rail (10) porteur, notamment boîtier d'électronique à rangées, le boîtier ayant une premier partie (2A, 6A, 12A) de boîtier, au moyen de laquelle l'appareil (2, 4, 6, 8, 12) peut être monté sur le rail (10) porteur, la première partie (2A, 6A, 12A) du boîtier ayant au moins deux dispositifs (28) de réception pour la fixation de, respectivement, un module (20, 24, 70, 74) de connexion sur la première partie (2A, 6A, 12A) du boîtier et dans lequel, sur les au moins deux dispositifs (28) de réception, montés, de préférence à distance l'un de l'autre, dans la première partie (2A, 6A, 12A) du boîtier, soit peut être fixé un module (20, 70) de connexion pour la connexion de lignes d'alimentation en énergie entre deux appareils (2, 4, 6, 8, 12) montés au voisinage l'un de l'autre sur le rail porteur, soit peut être fixé à un module (24, 74) de connexion pour la connexion de lignes de signaux entre deux appareils (2, 4, 6, 8, 12) montés au voisinage l'un de l'autre sur le rail porteur, le boîtier ayant une deuxième partie (2b, 6b) de boîtier, la deuxième partie (2b, 6b) de boîtier pouvant être assemblée de manière amovible à la première partie (2A, 6A, 12A) du boîtier à l'aide d'un moyen (78) d'encliquetage pouvant être dévié élastiquement, **caractérisé en ce que** la déviation du moyen (78) d'encliquetage peut être bloquée par un élément (80) de blocage monté mobile sur la deuxième partie (2b, 6b) du boîtier et ainsi l'état, assemblé à la première partie (2A, 6A, 12A) du boîtier, de la deuxième partie (2b, 6b) du boîtier, peut être assuré et **en ce que** l'élément (80) de blocage est monté mobile dans la deuxième partie (2b) du boîtier.

2. Boîtier suivant la revendication 1, **caractérisé en ce que** le module (20, 24, 70, 74) de connexion peut être fixé de manière détachable, notamment de manière détachable sans outil, à au moins l'un des dispositifs (28) de réception, de préférence à tous les dispositifs (28) de réception de la première partie (2A, 6A, 12A) du boîtier.

3. Boîtier suivant la revendication 1 ou 2, **caractérisé en ce que** un, de préférence tous les dispositifs (28) de réception, a au moins un élément (30) d'encliquetage avec lequel le module (20, 24, 70, 74) de connexion peut être mis en prise lors de la fixation sur la première partie (2A, 6A, 12A) du boîtier et **en ce qu'**au moins une partie des éléments (30) d'encliquetage est constituée en partie intégrante des parois (32) latérales de la première partie (2A, 6A, 12A) du boîtier, qui s'étendent transversalement à l'axe longitudinal du rail (10) porteur ou s'étendent transversalement à un axe longitudinal d'un logement (34) pour le rail (10) porteur, constitué, de préférence, d'une seule pièce par la première partie (2A, 6A, 12A) du boîtier.

4. Boîtier suivant l'une des revendications précédentes, **caractérisé en ce que**, dans au moins l'un des dispositifs (28) de réception, peut être fixé un module (20, 24, 70, 74) de connexion, auquel au moins une ligne de signaux, de préférence plusieurs lignes de signaux, peut être connectée entre deux appareils (2, 4, 6, 8, 12) montés au voisinage l'un de l'autre sur le rail (10) porteur.

5. Boîtier suivant l'une des revendications précédentes, **caractérisé en ce qu'**au moins l'un des modules (20, 24, 70, 74) de connexion, fixés dans la première partie (2A, 6A, 12A) du boîtier, a, sur ou près de ses bords opposés l'un à l'autre, respectivement, des points (40, 44) de connexion, notamment des contacts mâles pour la connexion de lignes de signaux d'alimentation en énergie à un appareil (2, 4, 6, 8, 12) monté voisin sur le rail (10) porteur, au moyen d'éléments (22, 26) de liaison, de préférence enfichables, et **en ce que**, entre les points de connexion, qui sont associés aux appareils (2, 4, 6, 8, 12) montés voisins sur le rail porteur, le module (20, 24, 70, 74) de connexion a au moins un autre point de connexion, notamment au moins un autre contact mâle pour des composants, disposés dans le boîtier, de l'appareil (2, 4, 6, 8, 12).

6. Système modulaire à boîtier pour des appareils (2, 4, 6, 8, 12) pouvant être montés et rangés les uns à côté des autres sur un rail (10) porteur, le système modulaire à boîtier, ayant un boîtier suivant l'une des revendications 1 à 5, ayant, dans au moins une dimension de construction, une première partie (2A, 6A, 12A) de boîtier, au moyen de laquelle l'appareil (2, 4, 6, 8, 12) peut être monté sur le rail (10) porteur,
dans lequel
le système modulaire à boîtier a à la fois au moins un module (20, 70) de connexion pour la connexion de lignes d'alimentation en énergie et aussi au moins un module (24, 74) de connexion pour la connexion de lignes de signaux, et dans lequel,
sur au moins deux dispositifs (28) de réception, montés de préférence à distance l'un de l'autre dans la première partie (2A, 6A, 12A) du boîtier, soit un module (20, 70) de connexion peut être fixé pour la connexion de lignes d'alimentation en énergie entre deux appareils (2, 4, 6, 8, 12) montés voisins l'un de l'autre sur le rail (10) porteur, soit un module (24, 74) de connexion peut être fixé pour la connexion de lignes de signaux entre deux appareils (2, 4, 6, 8, 12) montés au voisinage l'un de l'autre sur le rail (10) porteur.

7. Système modulaire à boîtier suivant la revendication 6, **caractérisé en ce que** le système modulaire à boîtier a, en outre, à la fois des éléments (22) connecteurs d'énergie, notamment des connecteurs électriques à enfichage pour la connexion de lignes d'alimentation en énergie et aussi des éléments (26) de connecteur de signaux, notamment des connecteurs électriques à enfichage pour la connexion de lignes de signaux.

8. Système modulaire à boîtier suivant la revendication 7, **caractérisé en ce que** le au moins un élément (22) connecteur d'énergie et/ou un élément (26) connecteur de signaux est multipolaire, de manière à pouvoir ainsi connecter plusieurs, et de préférence toutes les lignes d'alimentation en énergie et/ou les lignes de signaux à connecter entre deux appareils (2, 4, 6, 8, 12) montés au voisinage l'un de l'autre sur le rail (10) porteur.

9. Système modulaire à boîtier suivant la revendication 8, **caractérisé en ce que** l'élément (22) connecteur d'énergie et/ou l'élément (26) de connecteur de signaux multipolaire a, dans une partie enjambant les points de connexion aux éléments de connexion des appareils (2, 4, 6, 8, 12) voisins, un évidement (48), dans lequel la première partie (2A, 6A, 12A) du boîtier ou la deuxième partie (2B, 6B) du boîtier pouvant être reliée à la première partie (2A, 6A, 12A) du boîtier pénètre et ainsi fixe à complémentarité de forme la position de connexion de l'élément (22) de connecteur d'énergie et/ou de l'élément (26) de connecteur de signaux, notamment une position enfichée d'un connecteur multipolaire à enfichage.

10. Système modulaire à boîtier suivant l'une des revendications 6 à 9, **caractérisé en ce qu'**au moins une partie des modules (20, 24, 70, 74) de connexion des lignes d'alimentation en énergie a une rigidité diélectrique d'au moins 230 V, notamment d'au moins 380 V et de préférence d'au moins 500 V et/ou une aptitude à porter le courant d'au moins 5 A, notamment d'au moins 10 A et de préférence d'au moins 16 A.

11. Système modulaire à boîtier suivant l'une des revendications 7 à 10, **caractérisé en ce que** le au moins un connecteur électrique à enfichage a, pour l'enfichage dans un module (20, 24, 70, 74) de connexion, un organe (66) de contact, notamment en forme de fourche, déformable élastiquement, qui peut être enfiché dans une ouverture de l'élément (60) de contact du module (20, 70) de connexion.

12. Système modulaire à boîtier suivant l'une des revendications 6 à 11, **caractérisé en ce que** le système modulaire à boîtier a, en outre, une partie (12) de boîtier d'entrée, qui a des dispositifs (16) d'entrée de lignes d'alimentation en énergie et/ou des dispositifs (18) d'entrée de lignes de signaux et, en outre, au moins un module (20, 70) de connexion pour la connexion de lignes d'alimentation en énergie et/ou au moins un module (24, 74) de connexion pour la connexion de lignes de signaux à un appareil (2, 4, 6, 8, 12) monté au voisinage sur le rail (10) porteur.

13. Appareil (2, 4, 6, 8, 12) ayant un boîtier pouvant être monté sur un rail (10) porteur suivant l'une des revendications 1 à 5, dans lequel, sur les au moins deux dispositifs (28) de réception, montés de préférence à distance les uns des autres dans la première partie (2A, 6A, 12A) du boîtier, soit est fixé un module (20, 70) de connexion pour la connexion de lignes d'alimentation en énergie entre deux appareils (2, 4, 6, 8, 12) montés au voisinage les uns des autres sur le rail (10) porteur, soit est fixé un module (24, 74) de connexion pour le couplage de lignes de signaux entre deux appareils (2, 4, 6, 8, 12), montés au voisinage l'un de l'autre sur le rail (10) porteur et dans lequel deux modules (20, 24, 70, 74) de connexion, fixés au voisinage l'un de l'autre dans la première partie (2A, 6A, 12A) du boîtier, sont à distance l'un de l'autre.

14. Appareil (2, 4, 6, 8, 12) suivant la revendication 13, **caractérisé en ce que**, dans au moins l'un des dispositifs (28) de réception, est fixé un module (20, 24, 70, 74) de connexion, avec lequel peut être connectée au moins une ligne de signaux, notamment une ligne de signaux électriques et de préférence plusieurs lignes de signaux électriques, entre deux appareils (2, 4, 6, 8, 12), montés au voisinage l'un de l'autre sur le rail (10) porteur.
